# EUROPEAN PATENT APPLICATION

(11) **EP 4 459 682 A1**
(43) Date of publication of application: **06.11.2024**
(21) Application number: 23171311.6
(22) Date of filing: 03.05.2023
(51) Int. Cl.: H01L 31/0304, H01L 31/0687, H01L 31/0693

(54) **METHOD FOR MAKING MULTIJUNCTION PHOTOVOLTAIC DEVICE COMPRISING A GAASBI SUBCELL**

(71) Applicant: Valstybinis moksliniu tyrimu institutas Fiziniu ir technologijos mokslu centras, 10257 Vilnius (LT)
(72) Inventor: Paulauskas, Tadas, Vilnius (LT); Krotkus, Arunas, Vinius (LT); Pacebutas, Vaidas, Vilnius (LT); Geizutis, Andrejus, Vilnius (LT)
(74) Representative: Pakeniene, Ausra

(57) **Abstract**

The present invention provides a method to incorporate the GaAsBi subcell into a triple junction photovoltaic device in such a way as to avoid compromising its crystal structure by the growth of subsequent device layers. The obtained semiconductor multijunction photovoltaic device comprises at least two subcells one of which is GaAsBi alloy subcell forming a bottom subcell. A metamorphic buffer layer provides a transition to the larger constant GaAsBi subcell. A semiconductor contact layer (e.g., InGaAs) on the bottom GaAsBi subcell that is grown at equal or no greater than 80°C than the growth temperature of GaAsBi subcell, and the lattice constant of the contact layer that is nearly equal to GaAsBi in-plane lattice constant. The substrate, providing support for the growth, is removed after the bottom of the photovoltaic device is formed.

## Description

### TECHNICAL FIELD

The present invention relates to semiconductor multijunction photovoltaic devices that incorporate a bismuth containing GaAsBi alloy as one of its subcells.

### BACKGROUND ART

Multijunction photovoltaic devices are used to convert solar energy directly into electricity. These devices are comprised of several subcells that are monolithically grown on top of one another and are themselves connected in series by tunnelling diodes to allow the current to flow through the subcells. The top subcell, which is the one that receives the incident light first, absorbs the portion of the light that has the highest energy due to the largest bandgap of the top subcell [1]. By incident light we mean the solar spectrum reaching the ground, for example, the typical reference spectrum is global air mass 1.5 (AM1.5G). For space applications, the reference solar spectrum above the Earth's atmosphere is AM0.

The top subcell is transparent to the portion of the incident light which has energy lower than its bandgap, and a portion of this incident light that passed through is absorbed by the subcell below the top subcell having a lower bandgap than the top subcell. A triple junction solar cell is comprised of three subcells; the bottom subcell has the lowest bandgap energy and typically absorbs light in the infrared range.

The triple junction solar cell comprised of GaInP / InGaAs / Ge alloys, whereby GaInP is the top subcell and Ge is the bottom, is generally considered to be mature technology and has been widely used in space power applications. The bandgap combination of the top two subcells in this device can be tuned by varying the relative content of gallium (Ga) and indium (In) in the alloys but is typically chosen such that the lattice constants of all three subcells are equal to Ge (called lattice-matched). In particular, the device is typically grown on a Ge substrate with (001) crystal planes as its top surface. The lattice matched condition allows to avoid crystal dislocations, which can degrade the photovoltaic performance of the device. The bandgap combination of the GaInP / InGaAs / Ge device, when lattice-matched, is 1.81 / 1.41 / 0.67 electron-volts (eV). It is well known that such a bandgap combination is non-ideal to achieve the highest power conversion efficiency neither for ground-based nor for space-based applications.

The efficiency in multijunction solar cells is primarily limited by the generated voltage and current values. The voltage generated by a multijunction solar cell is the sum of each of the subcell's generated voltage. The higher the bandgap energy, the higher the voltage that can be achieved by that subcell. The photocurrent of the whole device, on the other hand, is equal to the photocurrent of the subcell which generates the least current. It is important to reach the highest current matching value between the subcells to achieve the highest efficiency. This can principally be done by changing the thickness of each subcell, thus allowing it to absorb a larger portion of the incident light, and/or by changing the bandgap energy values. However, since there is a compromise on multijunction solar cell efficiency between the current and its bandgap values, better efficiency can be achieved if in the GaInP / InGaAs / Ge device the bottom subcell Ge is replaced by a 1.0 eV bandgap subcell. This allows for increasing the overall device voltage while retaining sufficient photocurrent to gain efficiency [2].

The top two subcells, InGaP and InGaAs generating most of the triple junction device's power, typically remain lattice matched. However, the incorporation of an alternative bottom subcell that is of high crystal quality is problematic, because of the need to match the lattice constants. For example, In_{0.3}Ga_{0.7}As alloy with 1.0 eV bandgap has been widely explored in the so-called inverted growth method. In this method, the multijunction solar cell is grown on GaAs substrate starting from the top subcell first and is finalized with the bottom subcell. The substrate is then removed by etching or epitaxial lift-off techniques so that the incident light once again can reach the top subcell first. The In_{0.3}Ga_{0.7}As alloy is highly lattice mismatched with the top two subcells GaInP and GaAs, with its lattice constant being significantly larger. To incorporate In_{0.3}Ga_{0.7}As, several micrometers thick buffer layer is grown, composed of III-V semiconductor alloys by compositional grading to expand the lattice constant needed for the bottom subcell. Such a buffer allowing for the incorporation of another alloy on top is called a metamorphic buffer [3].

To decrease the complexity of such buffer layer and achieve better device reproducibility and throughput, it is desirable to use bottom subcell material which has lower lattice mismatch than In_{0.3}Ga_{0.7}As with the top subcells. Bismuth (Bi)-containing alloy GaAs₁₋ₓBiₓ allows for achieving the 1.0 eV bandgap energy with a much lower lattice mismatch than In_{0.3}Ga_{0.7}As [4]. As a result, a less complicated and thinner buffer layer is needed to incorporate GaAsBi in the multijunction solar cell [5].

GaAsBi alloy is known to be metastable, which means that low growth-temperatures, typically below 400 °C, are needed to incorporate Bi atoms and make GaAsBi alloy uniform. If higher Bi concentrations are required, the growth temperature needs to be lowered. By saying temperature, from here on we refer to the temperature of a device within a growth chamber as measured using a pyrometer. The GaAsBi alloy tends to decompose if it is heated significantly higher than its growth temperature, for example, by ejecting Bi from the lattice, forming Bi droplets, and generally phase-separating [6]. The multijunction solar cell incorporating GaAsBi as its subcell should also be preferably grown in the inverted method, so that higher temperatures that are typically needed to grow top subcells such as GaInP and GaAs, do not degrade GaAsBi subcell crystal structure.

US application, publication No.: US 2014/0326301A1, discloses bismuth-containing subcell alloy materials as possible realizations of new multijunction solar cell architectures. However, the Bi-containing subcells are suggested to be grown first before the top subcells or are placed somewhere in the middle of the devices. Of all the suggested alloys that could be used to form different subcells in the suggested devices, GaAsBi requires the lowest temperatures and therefore would be damaged by the growth of subcells or other active layers above it at higher temperatures.

There are numerous published investigations of GaAsBi-based solar cells [7, 8, 9]. However, all these realizations, and similar literature considering GaAsBi as being one of the constituent device elements, have not suggested a method to incorporate it safely. Even in single junction GaAsBi-based solar cell applications a contact layer is needed to finalize the structure, to which the semiconductor-metal ohmic contact is formed. In these instances, a typically employed GaAs is not favourable since it requires high temperatures and alters GaAsBi crystal structure, and, therefore, its photovoltaic properties.

The present invention is dedicated to overcoming the above shortcomings and for producing further advantages over prior art.

### BRIEF DESCRIPTION OF THE INVENTION

The method for making a multijunction photovoltaic device comprising GaAsBi as one of subcells comprises growing a GaAsBi subcell as a bottom subcell of a multijunction photovoltaic device. The device is grown in the inverted approach, such that the GaAsBi subcell is grown last after growing one or more other subcells having larger bandgaps and on top of the other subcells. The multijunction photovoltaic device is initially grown on a substrate with a smaller lattice constant than GaAsBi, for example, on GaAs substrate. GaAsBi is incorporated using a buffer layer to achieve a larger lattice constant equal to that of a cubic GaAsBi with a desired bandgap energy. The buffer layer can be composed of combinations of III-V elements, such as aluminum (Al), Ga, arsenic (As), In, antimony (Sb), Bi, and nitrogen (N), as chosen according to the device requirements. The bottom subcell GaAsBi is deposited at a desired growth temperature that allows for achieving optimal crystal structure and photovoltaic properties.

The lattice constant of a back contact alloy layer, preferably InGaAs, is adjusted based on the lattice relaxation of GaAsBi and the buffer layer beneath GaAsBi by varying In and Ga content. The InGaAs back contact layer, being the very last semiconductor contact layer in the device, is highly doped to achieve high carrier concentrations and can be grown at the same temperature as GaAsBi subcell. Furthermore, increasing the back contact layer growth temperature by no more than 80 °C above the growth temperature of GaAsBi subcell improves GaAsBi subcell photovoltaic properties. Such low-temperature annealing of GaAsBi can force further InGaAs buffer layer relaxation while avoiding Bi atom ejection from GaAsBi. Therefore, the intended back contact layer thickness is slightly larger to accommodate the additional relaxation of the buffer layer to match as closely as possible GaAsBi lattice constant. High carrier concentration and lower bandgap energy of the InGaAs back contact layer allow for the formation of low resistivity ohmic contact with standard metals.

The substrate can be removed by etching or epitaxial lift-off after the formation of the back contact, and standard processing steps are carried out to form the top solar cell contacts and complete the device. The present method can be applied to other optoelectronic devices, such as but not limited to solid-state lasers, diodes, and sensors, that require a high-quality GaAsBi subcell layer.

### BRIEF DESCRIPTION OF THE DRAWINGS

Features of the invention believed to be novel and inventive are set forth with particularity in the appended claims. The invention itself, however, may be best understood by reference to the following detailed description of the invention, which describes exemplary embodiments, given in non-restrictive examples, of the invention, taken in conjunction with the accompanying drawings, in which:
Fig. 1. shows a schematic diagram of an example of a photovoltaic device - a triple junction photovoltaic device, obtainable according to the method of the invention.
Fig. 2. shows a detailed schematic diagram of another example of a photovoltaic device according obtainable according to the method of the invention. Growth temperatures of different layers are shown to the right of the diagram. All different semiconducting alloy layers comprising the device are shown, including the range of proposed layer thicknesses.
Fig. 3. shows current-voltage data of the triple junction photovoltaic device with a bottom GaAsBi subcell.
Fig. 4. shows external quantum efficiency data of the triple junction photovoltaic device with a bottom GaAsBi subcell.

Preferred embodiments of the invention will be described herein below with reference to the drawings. Each figure contains the same numbering for the same or equivalent element.

### DETAILED DESCRIPTION OF THE INVENTION

It should be understood that numerous specific details are presented in order to provide a complete and comprehensible description of the invention embodiment. However, the person skilled in art will understand that the embodiment examples do not limit the application of the invention which can be implemented without these specific instructions. Well-known methods, procedures and components have not been described in detail for the embodiment to avoid misleading. Furthermore, this description should not be considered to be constraining the invention to given embodiment examples but only as one of possible implementations of the invention.

Method for making multijunction photovoltaic device comprises growing GaAsBi subcell as a bottom subcell (2), i.e., the GaAsBi subcell in all embodiments of the invention is the last subcell of a multijunction photovoltaic device. If more subcells are to be incorporated in the multijunction photovoltaic device above the GaAsBi subcell (2), the deposition of the further layers, or other processing steps of the device, for example, bonding, must not exceed 80 °C above the growth temperature of the GaAsBi alloy of the GaAsBi subcell. The multijunction photovoltaic device is grown in inverted approach, i.e., the GaAsBi subcell (2) is grown last and on top of first subcells having larger bandgaps. The first subcells comprises one or more subcells, preferably two subcells. The device is initially grown on a substrate with a smaller lattice constant than GaAsBi, for example, on a GaAs substrate. GaAsBi is incorporated using a buffer layer to achieve a larger lattice constant equal to that of a cubic GaAsBi with a desired bandgap energy. The buffer layer comprises combinations of III-V elements, such as Al, Ga, As, In, Sb, Bi, N. The bottom GaAsBi subcell (2) is deposited at temperature that allows achieving optimal crystal structure and photovoltaic properties of the multijunction photovoltaic device. Lattice constant of a back contact alloy layer, preferably consisting of InGaAs, is adjusted based on the lattice relaxation of GaAsBi and the buffer layer beneath GaAsBi by varying In and Ga content. The InGaAs back contact layer (1) being the very last semiconductor contact layer in the multijunction photovoltaic device is highly doped to achieve high carrier concentrations and can be grown at the same temperature as GaAsBi. Furthermore, increasing the back contact (1) growth temperature by no more than 80 °C above the growth temperature of GaAsBi subcell improves GaAsBi photovoltaic properties of the multijunction photovoltaic device. Such low-temperature annealing of GaAsBi can force further InGaAs buffer layer relaxation while avoiding Bi atom ejection from GaAsBi. Therefore, the back contact layer (1) thickness is slightly larger to accommodate additional relaxation of the buffer layer to match as closely as possible GaAsBi lattice constant. High carrier concentration and lower bandgap energy of the InGaAs back contact (1) allow for the formation of low resistivity ohmic contact with standard metals. The substrate is removed by etching or epitaxial lift-off after the formation of the back contact (1), and standard processing steps are carried out to form the front contact and complete the multijunction photovoltaic device.

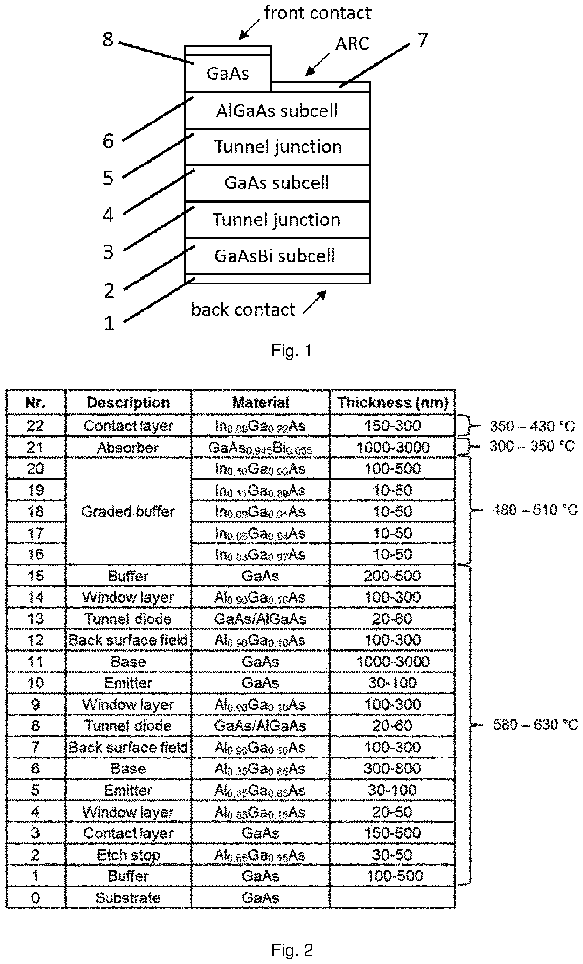

Fig. 1 depicts a cross-section diagram of an example of multijunction photovoltaic device obtainable according to the method of the invention. The multijunction photovoltaic device is a complete solar cell. The multijunction photovoltaic device comprises a back contact (1), a bottom subcell (2) being GaAsBi subcell, a first tunnel junction (3), a middle subcell (4), a second tunnel junction (5), a top subcell (6), an antireflection coating (7), a front contact (8). The front contact (8) is formed in the shape of a grid, and the shape can vary and is optimized according to the device's requirements. The top subcell (6) is made of alloy, such as AlGaAs, with a bandgap energy in the range 1.82 -1.91 eV. The middle subcell (4) is made of alloy, such as GaAs, with a bandgap energy of 1.42 eV and is lattice matched to the top subcell (6). The bottom subcell (2) is made of GaAsBi alloy having larger lattice constant than the top two subcells and a bandgap energy of 1.0 eV. The subcells (2, 4, 6) are interconnected by tunnelling junctions (3, 5), which can themselves be made of GaAs and AlGaAs alloys.

The middle subcell (4), a growth substrate, such as GaAs, can be removed from the photovoltaic device making the photovoltaic device a thin film device.

Even though a triple junction photovoltaic device is depicted, the device can have any number of subcells, not necessarily three, as long as the GaAsBi subcell is the last subcell. If subcells are to be incorporated in the multijunction photovoltaic device above the GaAsBi subcell (2), the deposition of the further layers, or other processing steps of the device, for example, bonding, must not exceed 80 °C above the growth temperature of the GaAsBi alloy of the GaAsBi subcell.

The multijunction photovoltaic device may comprise other standard collar cell elements to function as a solar cell and be handled with ease.

Fig. 2 shows another example of a triple junction photovoltaic device obtainable according to the method of the invention. The triple junction photovoltaic device as shown in Fig. 2 is essentially the same as depicted in Fig. 1 but comprising initially grown semiconductor layers, including the growth substrate GaAs, still intact as they are after the device would have completed its growth process. The layer thicknesses are in a range to optimize the device efficiency under standard operating conditions. However, there are no restrictions on the layer thicknesses up to layer labelled Nr. 22. The contact layer labelled Nr. 22 growth time should not exceed 1 hour, if its growth temperature is more than 80 °C larger than the growth temperature of GaAsBi alloy. Thus, growth rate and layer thickness need to be optimized accordingly.

The photovoltaic device of the second example comprises a semi-insulating GaAs substrate, labelled Nr. 0; a GaAs buffer layer, labelled Nr. 1; an etch-stop layer, labelled Nr. 2, which is used to assist with device processing if the GaAs substrate is chosen to be etched away afterward rather than being lifted-off. There can be more or fewer than two first layers after the GaAs substrate and can be chosen based on the subsequent substrate processing requirements. The photovoltaic device as shown in Fig. 2 also comprises GaAs contact layer, labelled Nr. 3; an AlGaAs window layer, labelled Nr. 4; a p-n diode comprised of emitter labelled Nr. 5 and base AlGaAs layers labelled Nr.6; back surface field layer labelled Nr. 7. The layers labelled Nr. 4 to 7 comprise the top AIGaAs subcell (6) as in the example of the triple junction solar cell as shown in Fig. 1. The first tunnel diode labelled Nr. 8 is comprised of two highly doped thin layers (not shown in the diagram) comprising p-n diode with opposite polarity than the p-n diodes comprising the subcells. The tunnel diode can be made of two GaAs layers, or AlGaAs and GaAs. The following layers labelled Nr. 9 to 12 comprise the middle GaAs subcell (4) as in the example of the triple junction solar cell as shown in Fig. 1. The second tunnel diode labelled Nr. 13 can be made the same way as the first tunnel diode described above.

The following layers labelled Nr. 14 to 22 comprise the bottom GaAsBi subcell (2) as in the example of the triple junction solar cell as shown in Fig. 1. A GaAs buffer layer labelled Nr. 15 is followed by compositionally graded InGaAs buffer labelled Nr. 16 to 20. The buffer layer is made with increasing content of In, which causes the crystal lattice constant to expand. In this process, dislocations are generated, but they mostly remain confined within the graded buffer layer. The final InGaAs buffer layer has slightly lower In content than the one below. It is also thicker to make the growth surface more even for the deposition of GaAsBi alloy. The buffer layer labelled Nr. 16 to 20, does not have to be necessarily InGaAs. Other III-V semiconductor alloys can be used that allow expanding the lattice constant beyond GaAs and that do not strongly absorb in the spectral region in which GaAsBi subcell should be operating. The GaAsBi alloy absorber layer labelled Nr. 21 can be either doped p- or n-type or left undoped. In the latter case, and as is proposed in this device, it would have an intrinsic (i) carrier concentration, which is typically slightly p-type. The semiconductor device growth is finalized with the InGaAs contact layer labelled Nr. 22. Layers labelled Nr. 20 to 22 comprise a p-i-n diode, since GaAsBi is left undoped.

The InGaAs contact layer labelled Nr. 22 growth temperature is reduced, compared to the graded buffer InGaAs layers labelled Nr. 16 to 20, such that it is no higher than 80 °C above GaAsBi growth temperature. The reduction of InGaAs growth temperature by the proposed amount does not deteriorate its crystal quality, nor has other detrimental effects on its ability to act as a low resistivity contact layer with a metal that is deposited on top. The InGaAs contact layer is preferably highly doped, on the order of 1e19 cm⁻³ if p-type, or at least 8e18 cm⁻³ if it is n-type. Also, In concentration of the InGaAs contact layer labelled Nr. 22, which is 8% here, is adjusted to obtain lattice matching with the underlying GaAsBi, by considering the lattice relaxation of the GaAsBi layer.

Typical growth temperatures of: AIGaAs and GaAs subcells is 580 - 630 °C, graded InGaAs buffer is 480 - 510 °C, and GaAsBi is 300 - 350 °C. The indicated GaAsBi growth temperatures refer to GaAsBi with Bi content such that a 1.0 eV bandgap can be achieved with good material quality.

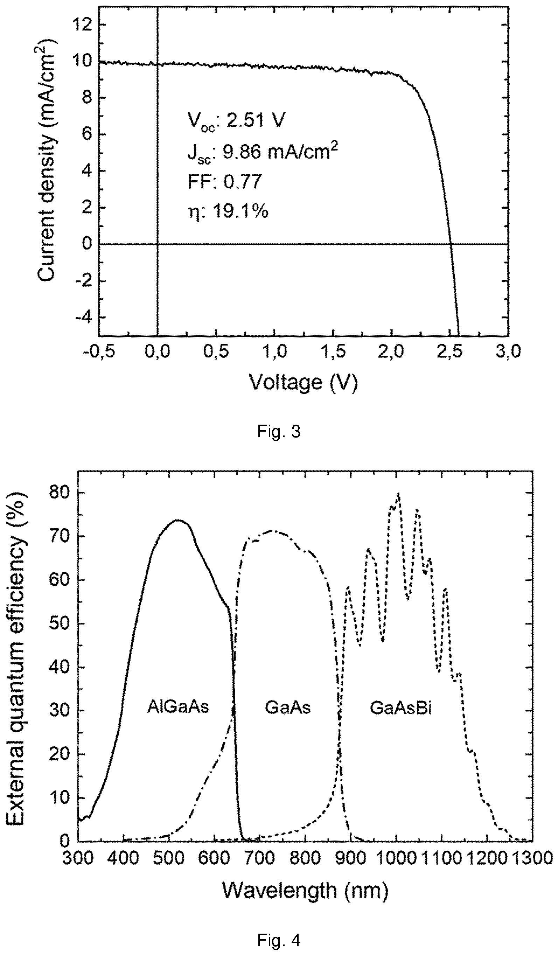

Current density-voltage measurements of the triple junction photovoltaic device according to the invention is shown in Fig. 3. The bottom subcell (2) GaAsBi absorber thickness in the first example was 1200 nm. The measurements were conducted at room temperature by illuminating a completed mesa structure device with a total area of 0.2 cm² using an AM1.5G solar spectrum simulator. A double layer TiO₂/SiO₂ antireflective coating was deposited on the completed device after etching the GaAs contact layer. The GaAs substrate was removed by etching. The photovoltaic device efficiency (η) was measured to be 19.1 %, open-circuit voltage (V_{oc}) 2.51 V, short-circuit current density (J_{sc}) 9.86 mA/cm², and fill-factor (FF) 0.77. This demonstrates that a highly functional triple junction solar containing GaAsBi alloy is manufactured.

External quantum efficiency (EQE) measurement of the triple junction photovoltaic device according to the invention is shown in Fig. 4. The bottom GaAsBi subcell (2) shows spectral response down to 1250 nm wavelength, indicating its bandgap is 0.99 eV, close to the target bandgap of 1.0 eV. The bandgap combination of the triple junction device is 1.87 / 1.42 / 0.99 eV. The interference effects in GaAsBi EQE appear due to the incident light in the infrared portion of the spectrum that is not fully absorbed in the first pass through the GaAsBi absorber and being reflected from the back contact interfering within the device with the light field.

The present method can be applied to other optoelectronic devices, such as but not limited to solid-state lasers, diodes, and sensors, that require a high-quality GaAsBi layer.

Although numerous characteristics and advantages together with structural details and features have been listed in the present description of the invention, the description is provided as an example fulfilment of the invention. Without departing from the principles of the invention, there may be changes in the details, especially in the form, size and layout, in accordance with the most widely understood meanings of the concepts and definitions used in claims.

### Citations:

[1] USA patent - US 8,697.481 B2 (2014. 04. 15)
[2] R. M. France, John F. Geisz, Tao Song, Waldo Olavarria, Michelle Young, Alan Kibbler, Myles A. Steiner, "Triple-junction solar cells with 39.5% terrestrial and 34.2% space efficiency enabled by thick quantum well superlattices", Joule 6, 5, 1121-1135, (2022). https://doi.org/10.1016/j.joule.2022.04.024
[3] USA patent - US 7.633,083 B2 (2009. 11. 15)
[4] Bismuth-Containing Alloys and Nanostructures, Eds S. Wang and P. Lu, Springer, Singapore, (2019), https://doi.org/10.1007/978-981-13-8078-5
[5] 15. T Paulauskas et al, "Epitaxial growth of GaAsBi on thin step-graded InGaAs buffer layers", Semicond. Sci. Technol. 37 065004, (2022). https://doi.org/10.1088/1361-6641/ac61ff
[6] Paulauskas, T., Pa 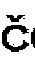 ebutas, V., Gei 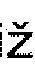 utis, A. et al. "GaAs1-xBix growth on Ge: anti-phase domains, ordering, and exciton localization", Sci Rep 10, 2002 (2020). https://doi.org/10.1038/s41598-020-58812-y
[7] H. Kawata, S. Hasegawa, H. Nishinaka, M. Yoshimoto, Improving the photovoltaic properties of GaAs/GaAsBi pin diodes by inserting a compositionally graded layer at the hetero-interface, Semicond. Sci. Technol. 37 (2022), 065016, https://doi.org/10.1088/1361-6641/ac66fa
[8] J. Thomas et al, "Requirements for a GaAsBi 1eV sub-cell in a GaAs-based multi-junction solar cell", Semicond. Sci. Technol. 30 (2015) 094010, https://doi.org/10.1088/0268-1242/30/9/094010
[9] S. Hasegawa, K. Kakuyama, H. Nishinaka, M. Yoshimoto, "PEDOT:PSS/GaAs1-xBix organic-inorganic solar cells", Japanese Journal of Applied Physics 58, 060907 (2019), https://doi.org/10.7567/1347-4065/ab1e97

## Claims

1. A method for making a multijunction photovoltaic device comprising growing multiple subcells, tunnel junctions in between the subcells, a front contact and a back contact **characterised in that** the method comprises
growing the multijunction photovoltaic device on a support substrate with a smaller lattice constant than GaAsBi,
growing a bottom subcell (2) consisting of GaAsBi, where
the GaAsBi subcell (2) is grown last on top of the previous subcells having larger bandgaps,
if subcells are grown above the GaAsBi subcell (2), growth temperature of such subcells does not exceed 80 °C above the growth temperature of the GaAsBi alloy of the GaAsBi subcell (2),
GaAsBi subcell (2) is incorporated using a buffer layer to achieve a larger lattice constant equal to that of a cubic GaAsBi,
the bottom subcell GaAsBi (2) is deposited at a temperature that allows achieving optimal crystal structure and photovoltaic properties of the multijunction photovoltaic device,
growing last layer of the multijunction photovoltaic device as a back contact layer (1) and doping the back contact layer (1) to obtain a highly doped back contact layer (1),
where the back contact layer (1) is grown at the same temperature or at no greater temperature than 80 °C above the GaAsBi bottom subcell (2) growth temperature,
where lattice constant of the back contact layer (1) is adjusted based on lattice relaxation of GaAsBi and the buffer layer beneath GaAsBi by varying In and Ga content,
where the subcells (2, 4, 6) are grown one on top of each other using metamorphic buffer layers if the subcell alloy lattice constants are not equal.

2. Method according to claim 1, where doping of InGaAs contact layer is preferably on the order of 1e19 cm⁻³ if p-type, or at least 8e18 cm⁻³ if it is n-type.

3. Method according to any previous claims, where
the support substrate is selected from GaAs, Ge, Si, InP, GaP, GaSb, InAs, InSb,
the at least one other subcell (4, 6) comprises semiconductor alloys comprising elements selected from Al, Ga, In, Ge, Sn, Si, P, As, Sb, N, Bi,
the tunnel junctions for interconnecting the subcells comprises semiconductor alloys comprising elements selected from Al, Ga, In, Ge, Sn, Si, P, As, Sb, N, Bi,
the back contact layer (1) consists of an alloy comprising combinations of elements Al, Ga, In, Ge, Sn, Si, P, As, Sb, N, Bi.

4. Method according to any previous claims, where the buffer layer consists of alloys comprising combinations of elements Al, Ga, In, Ge, Sn, Si, P, As, Sb, N, Bi.

5. Method according to any previous claims, where lattice constant of a back contact layer (1) consists of InGaAs.

6. Method according to any previous claims, where growth temperatures of layers are:
580 °C to 630 °C for AlGaAs and GaAs subcells (4, 6), grown before the GaAsBi bottom subcell (2),
480 °C to 510 °C for graded InGaAs buffer,
300 °C to 350 °C for GaAsBi bottom subcell (2).

7. Method according to claim 6, where the back contact layer (1) growth temperature is increased by ≤ 80 °C above the growth temperature of GaAsBi.

8. Method according to any previous claims, where the support substrate has smaller lattice constant than GaAsBi bottom subcell (2).

9. Method according to any previous claims, where
the top subcell (6) is made of alloy, such as AlGaAs, with a bandgap energy in the range 1.82 - 1.91 eV,
the middle subcell (4) is made of alloy, such as GaAs, with a bandgap energy of 1.42 eV and is lattice matched to the top subcell (6),
the bottom subcell (2) is made of GaAsBi alloy having larger lattice constant than the first subcells and a bandgap energy of 1.0 eV,
the subcells (2, 4, 6) are interconnected by tunnelling junctions (3, 5), such as diodes, which can themselves be made of GaAs and AlGaAs alloys.
